(19) Europäisches Patentamt
European Patent Office
Office européen des brevets

(11) **EP 2 246 184 A1**

(12) **EUROPEAN PATENT APPLICATION**
published in accordance with Art. 153(4) EPC

(43) Date of publication:
03.11.2010 Bulletin 2010/44

(51) Int Cl.:
*B32B 15/08* (2006.01)    *B32B 15/088* (2006.01)
*H01B 17/62* (2006.01)    *H05K 1/03* (2006.01)

(21) Application number: 09702944.1

(22) Date of filing: 15.01.2009

(86) International application number:
PCT/JP2009/050485

(87) International publication number:
WO 2009/091005 (23.07.2009 Gazette 2009/30)

(84) Designated Contracting States:
AT BE BG CH CY CZ DE DK EE ES FI FR GB GR
HR HU IE IS IT LI LT LU LV MC MK MT NL NO PL
PT RO SE SI SK TR
Designated Extension States:
AL BA RS

(30) Priority: 18.01.2008  JP 2008009886
25.06.2008  JP 2008166402

(71) Applicant: The Furukawa Electric Co., Ltd.
Chiyoda-ku
Tokyo 100-8322 (JP)

(72) Inventors:
• TACHIBANA, Akira
Tokyo 100-8322 (JP)
• INUKAI, Toshiyuki
Tokyo 100-8322 (JP)
• SUGAHARA, Chikahito
Tokyo 100-8322 (JP)
• MORII, Akira
Tokyo 100-8322 (JP)

(74) Representative: Forstmeyer, Dietmar et al
BOETERS & LIECK
Oberanger 32
80331 München (DE)

(54) **COMPOSITE MATERIAL FOR ELECTRICAL/ELECTRONIC COMPONENT, ELECTRICAL/ ELECTRONIC COMPONENT, AND METHOD FOR PRODUCING COMPOSITE MATERIAL FOR ELECTRICAL/ELECTRONIC COMPONENT**

(57) Disclosed is a composite material for electrical/ electronic component, having a resin coating film formed on at least a part of a metal base, and the residual solvent quantity in the resin coating film being controlled to be 1-30% by mass. The resin coating film is preferably composed of a polyimide or a polyamide-imide.

Fig. 1

EP 2 246 184 A1

**Description**

TECHNICAL FIELD

The present invention relates to a composite material for electrical/electronic component having a resin coating film on a metal base, an electrical/electronic component and a method for producing a composite material for electrical/ electronic component.

BACKGROUND ART

On a printed circuit board of an electric/electronic device, separate elements, such as a ceramic oscillator, a crystal oscillator, a voltage controlled oscillator, a SAW filter, a diplexer, a coupler, a balun, an LPF, a BPF, or a dielectric duplexer, various modules each having a plurality of such elements integrated therein, such as an antenna switch module, a front end module, an RF integrated module, a radio communication module, an image sensor module, a tuner module, or a wireless LAN module, or components such as a detection switch are mounted. These are used inside a metal case or covered with a cover for electromagnetic shield. Recently, while more electric/electronic devices become portable, the case is required to be thinner and smaller and its height is 5 mm for modules, and less than 2 mm or around 1 mm for separate elements. A terminal connector at the printed circuit board side such as a mother board, a keyboard or an LCD (Liquid Crystal Display), and a connector at the side of an FPC cable are required to have electromagnetic shield and are used as covered with a conductive metal case, cap or cover. They are also being smaller and thinner, and connectors and sockets are also being miniaturized.

However, if the above-mentioned metal case becomes smaller, the internal volume becomes smaller, and there occur a problem that insulation between the inner components, terminals and wiring circuits and the electrical/ electronic component such as case, cover, cap or package (cover case) is not assured. Then, in the conventional art, as described in the patent document 1, an insulation film is cut into a sheet of predetermined dimensions and inserted into the case or, as disclosed in the patent document 2, a resin coating film is formed on a metal base into a metal material, which is then cut by predetermined dimensions. Use of a material having a resin coating film formed on a metal material in advance is preferable in view of economy or productivity as punching or bending working can be performed continuously. Besides, the material is such that it can be coated continuously and with high quality at a part, entire surface or double surfaces thereof as desired, recently, it tends to be used well.

With miniaturizing and sophistication of digital devices or portable devices, there are many restrictions put on the shape of an electrical/electronic component mounted thereon. Therefore, working into a desired shape becomes severe and adhesion in various working process needs to be enhanced. In order to enhance adhesion between the metal base and resin coating film, for example, some methods are shown: the metal base is coated at the surface with a coupling agent (Patent document 3) and a plated layer having a dendrite crystal is formed on a surface of the metal base (Patent document 4).

In addition, as forming of a composite material of a metal base and a resin coating, there are known a method of, when coating a heat resistant resin solution continuously on a metal foil and drying the metal foil to be a flexible metal laminated material, rolling the material with a predetermined amount or more of solvent left thereon and subjecting the material to heat treatment while controlling ridge reaction between solvent removal and the resin thereby to manufacture the flexible metal laminated material (see Patent document 5) or a method of producing a metal laminated plate of one or more polyimide resin layers and a metal conductor, in which the first polyimide resin layer in contact with the conductor is composed almost exclusively of aromatic polybasic acid, its acid anhydride, diamine and diisocyanate and the residual solvent quantity in the first polyimide resin layer is 20 to 30 % by mass (for example, see patent document 6) thereby to prevent occurrence of curling in the manufacturing process.

Here, when the composite material having an insulating coating film on the metal base is used as a material for the electrical/electronic component, as this material has an insulating coating film on the metal base, it can be used in various applications by being subjected to working such as punching at a part containing a boundary face between the metal base and the insulating coating film to form a connector contact or the like and arranging such connector contacts at a narrow pitch. Or, after punching, the material is subjected bending working thereby to be applicable to electrical/electronic components having various functions.

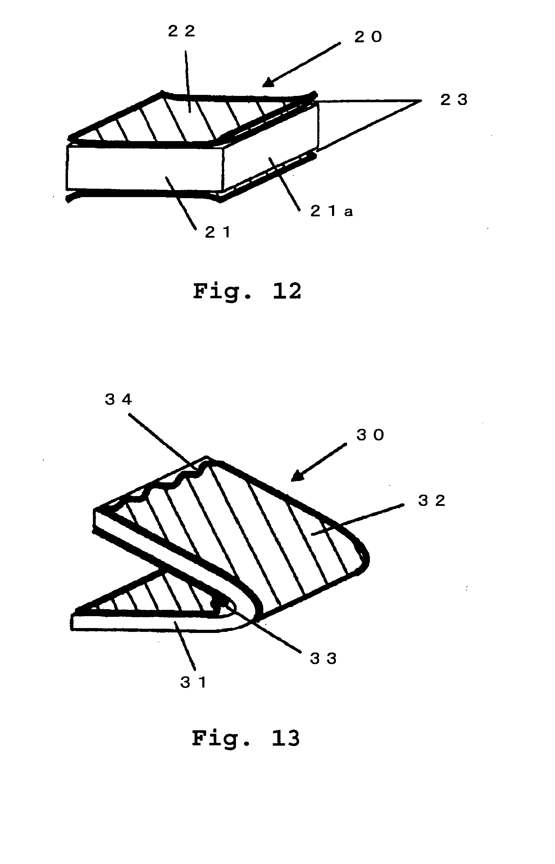

When this composite material is subjected to working such as punching at a part including a boundary face between the metal base and the insulating coating film, a small gap of several $\mu$m or several tens $\mu$m is sometimes formed at the worked part between the metal base and the insulating coating film. This gap is thought to be formed by insufficient adhesion between the metal base and the resin coating film. This state is schematically illustrated in Fig. 12. In Fig. 12, 20 denotes a electrical/electronic component, 21 denotes a metal base, 22 denotes an insulating coating film, and a gap 23 is formed between the metal base 21 and the insulating coating film 22 in the vicinity of a punched surface 21a of the metal base 21. This tendency becomes strong as the clearance becomes larger in punching (for example, 5% or more relative to the thickness of the metal base). As there is actually an upper limit for reducing of the clearance in punching, it can be said that this tendency becomes increased as the above-mentioned worked piece is more miniaturized.

In such a state, due to secular changes in punching or the like, the insulating coating film 22 becomes completely peeled off from the metal base 21 and provision of the insulating coating film 22 on the metal base 21 becomes meaningless. Besides, depositing of the insulating coating film after fine working needs much time and effort and brings about cost increases, which is not practical. Further, if a metal exposed surface of the electrical/electronic component formed (for example, punched surface 21a) is to be used as a connector contact or the like, a metal layer is later formed on the metal exposed surface (for example, punched surface 21a) by plating, however, when it is immersed in a plating liquid, the plating liquid sometimes flows via the gap 23, which may cause peeling off of the insulating coating film 22 from the metal base 21.

Besides, when bending is performed after punching, even if no gap is formed between the metal base and the insulating coating film at a worked part in the process of punching or the like, a gap is sometimes formed between the metal base and the insulating coating film after bending is performed. This is schematically illustrated in Fig. 13. In Fig. 13, 30 denotes an electrical/electronic component, 31 denotes a metal base, 32 denotes an insulating coating film, and a gap 33 is formed at an inner side of a bent part of the metal base 31 and a gap 34 is formed at an end (particularly at an outer side of the bent part) of the electrical/electronic component 30. As illustrated in Fig. 13, these gaps are prominently formed at the inner surface side and side surface of the bent part of the bent electrical/electronic component and at the end of the electrical/electronic component, and they may cause peeling off of the insulating coating film 22 from the metal base 31.

Patent document 1: Japanese Patent Application Laid-open No. 1-6389
Patent document 2: Japanese Patent Application Laid-open No. 2004-197224
Patent document 3: Japanese Patent No. 2802402
Patent document 4: Japanese Patent Application Laid-open No. 5-245432
Patent document 5: Japanese Patent Application Laid-open No. 2001-105530
Patent document 6: Japanese Patent Application Laid-open No. 2005-117058

SUMMARY OF THE INVENTION

PROBLEMS TO BE SOLVED BY THE INVENTION

However, even in combination of the techniques disclosed in the above-mentioned patent documents, it is difficult to solve the problems of insufficient adhesion between the metal base and the resin coating film in precision press working, high-temperature treatment, plating and the like when manufacturing of an electrical/electronic component mounted and used in a portable device, digital device or the like. This is explained in more detail below.

The techniques disclosed in the patent documents 1 and 2 do not assume post treatment such as plating, high-temperature treatment or precision press working in manufacturing of the electrical/electronic component and these documents do not describe enhancement of adhesion between the metal base and the resin coating film in the electrical/electronic component to such a degree that they can resist the post treatment.

As to the method of coating a coupling agent as disclosed in the patent document 3, as the liquid life duration of the coupling agent is short there is a need to pay due attention to management of the liquid. In addition, as it is difficult to perform treatment evenly on the entire surface of the metal base, this method is not effective for the above-mentioned small gap. As the method of forming a plated layer having dendrite crystal disclosed in the patent document 4, as plating needs to be performed on the restricted plating conditions to control a crystal state of the formed plated layer, there is a need to pay due attention to management. Further, in order to assure enough adhesion, the plating thickness needs to be 1 μm or more, which causes problems of cracking in the plated layer in punching or economically unfavorable.

Further, the techniques disclosed in the patent documents 5 and 6 are presented to adjust a residual solvent quantity during manufacturing in order to prevent occurrence of curl in the manufacturing and are not linked to enhancement of the adhesion between metal base and the resin coating film.

Then, in order to obtain a metal resin composite material (hereinafter referred to simply as "composite material") suitable for use in an electrical/electronic component that is to be subjected to working such as a shield case, a connector, a terminal and the like and also to solve the above-mentioned problems, the present invention has an object to provide metal resin composite material for electrical/electronic component which is extremely excellent in workability by press such as punching or bending by enhancing adhesion between a metal base and a resin coating film and can hold high degree of adhesion between the metal base and the resin coating film even after heat treatment, plating or the like.

MEANS FOR SOLVING THE PROBLEMS

In view of the above-mentioned problems, the present inventors and so on studied eagerly and have found that the production method by heating the resin coating film for a long time and reducing a solvent in the resin coating film as much as possible thereby to get the best resin property is common, when considering adhesion between the metal and the resin, is can be enhance by leaving an appropriate amount of the solvent and improve workability. Then, they have found that by clarifying relation between the adhesion and a final residual solvent and leave the residual solvent appropriately, the adhesion between metal and resin can be enhanced without any special treatment, and have advanced the study and completed the present invention.

The present invention provides the following:

(1) a composite material for electrical/electronic component, having a resin coating film formed on at least a part of a metal base, and a residual solvent quantity in the resin coating film being controlled to be 1-30% by mass;

(2) a composite material for electrical/electronic component, having a resin coating film formed by coating at least a part of a metal base with a varnish containing a resin or a resin precursor dissolved in a solvent and performed heating treatment for reaction curing, and the composite material being to be subjected to press working, wherein a residual solvent quantity after reaction curing of the resin coating film is controlled to be 1 to 30% by mass so that adhesion between the resin coating film and the metal base in the press working and press workability are both excellent;

(3) the composite material of (1) or (2), wherein the resin coating film is composed of a polyimide or a polyamide-imide;

(4) the composite material of any one of (1) to (3), wherein the metal base is of copper, copper alloy, iron or iron alloy;

(5) the composite material of any one of (1) to (4), wherein the residual solvent quantity is controlled to be 3 to 20% by mass;

(6) the composite material of any one of (1) to (4), wherein the residual solvent quantity is controlled to be 5 to 15% by mass;

(7) an electrical/electronic component using the composite material of any one of (1) to (6);

(8) a method for producing the composite material of any one of (1) to (6), comprising performing the reaction curing of the resin coating film at temperatures of 100 to 500 degrees; and

(9) the method of (8), wherein the reaction curing of the resin coating film is performed at a temperature rising speed of 45 °C/second or less.

EFFECTS OF THE INVENTION

In the composite material for electrical/electronic component of the present invention, punching and bending workability by pressing can be improved by enhancing adhesion between the resin coating film and metal. Besides, when the composite material for electrical/electronic component is produced under the above-mentioned conditions, the resin itself becomes softer than a completely cured resin, and therefore, bending by pressing can be improved and workability by pressing can be facilitated advantageously.

Further, as the composite material for electrical/electronic component of the present invention has improved adhesion between the resin coating film and the metal, it is excellent in reflow resistance, alkaliproof and the like and is well enough to resist post treatments after working such as heat treatment and plating

The above-mentioned and other features and advantages of the present invention will be apparent from the following description with reference to the attached drawings when appropriate.

BRIEF DESCRIPTION OF THE DRAWINGS

Fig. 1 is an enlarged cross-sectional view illustrating a composite material for electric/electronic component according to a first exemplary embodiment of the present invention;

Fig. 2 is an enlarged cross-sectional view illustrating a composite material for electric/electronic component according to a second exemplary embodiment of the present invention;

Fig. 3 is an enlarged cross-sectional view illustrating a composite material for electric/electronic component according to a third exemplary embodiment of the present invention;

Fig. 4 is an enlarged cross-sectional view illustrating a composite material for electric/electronic component according to a fourth exemplary embodiment of the present invention;

Fig. 5 is an enlarged cross-sectional view illustrating a composite material for electric/electronic component according to a fifth exemplary embodiment of the present invention;

Fig. 6 is an enlarged cross-sectional view illustrating a composite material for electric/electronic component according to a sixth exemplary embodiment of the present invention;

Fig. 7 is an enlarged cross-sectional view illustrating a composite material for electric/electronic component according to a seventh exemplary embodiment of the present invention;

Fig. 8 is a plan view illustrating a composite material for electric/electronic component according to an eighth exemplary embodiment of the present invention;

Fig. 9 is a plan view illustrating a composite material for electric/electronic component according to a ninth exemplary embodiment of the present invention;

Fig. 10 is an enlarged cross-sectional view illustrating a composite material for electric/electronic component according to a tenth exemplary embodiment of the present invention;

Fig. 11 is a graph illustrating relation between peel strength and residual solvent quantity;

Fig. 12 is a conceptual view illustrating an example in which a gap is formed between a metal base and an insulating coating film; and

Fig. 13 is a conceptual view illustrating an example in which a gap is formed between a metal base and an insulating coating film.

REFERENCE NUMERALS

1 metal base
2 resin coating film
3 Ni layer
4 Sn layer
20 electric/electronic component
21 metal base
21a punched surface
22 insulating coating film
23 gap
30 electric/electronic component
31 metal base
32 insulating coating film
33, 34 gap

BEST MODE FOR CARRYING OUT THE INVENTION

The composite material for electrical/electronic component of the present invention has a resin coating film formed on at least a part of a metal base. Then, its residual solvent quantity ranges from 1 to 30%, preferably 3 to 20% or more preferably 5 to 15%. If the residual solvent quantity is too small, adhesion between the resin coating film and metal is reduced. If the residual solvent quantity is too large, adhesion between the resin coating film and metal is reduced and curing of the resin becomes insufficient so that it cannot be worked as a component.

Here, the residual solvent quantity is a mass of the solvent remaining in the resin coating film with respect to a mass of the cured resin of the finally-obtained composite material for electrical/electronic component and can be expressed by the following equation.

$$\text{Residual solvent quantity (\% by mass)} = \text{(residual solvent mass/resin coating film mass)} \times 100 \, (\%)$$

The residual solvent mass can be measured by chromatography (GC), Thermo Gravimeter - Differential Thermal Analysis (TG-DTA), Thermo Gravimeter - Differential Scanning Calorimeter (TG-DSC) and the like. A desired residual solvent quantity can be obtained, for example, by determining conditions such as time and curing temperature of the resin appropriately.

Then, these conditions are determined to produce a composite material for electrical/electronic component.

In the present invention, the metal base may be made of metal materials of various shapes, among which metal strip, metal foil and metal plate are used mainly. When the substrate is thinner, the strength of the worked piece becomes insufficient and if it is too thick, press punching and bending are difficult to perform. Hence, the substrate thickness preferably ranges from 0.01 to 1 mm, or more preferably, 0.05 to 0.5 mm, though it depends on the use purpose of composite material.

In the present invention, the metal base uses a material having ductility so that punching and squeezing are allowed or a metal material having spring property. Specifically, the metal base materials include pure copper materials such as oxygen free high conductivity copper and tough pitch copper, copper base alloy materials such as nickel silver (Cu-Ni system alloy), phosphor bronze (Cu-Sn-P system alloy) and Corson alloy (Cu-Ni-Si system alloy), pure iron materials, iron base alloy materials such as 42 alloy (Fe-Ni alloy) and stainless steel.

In the present invention, the electric characteristic is preferably an appropriate value for the use purpose of the composite material. For example, in the case of the use for electromagnetic shield (shield cases), the electrical conductivity is preferably 5%IACS or more, or more preferably, 10%IACS or more in view of the electromagnetic shield property. The specific permeability is preferably 1 or more.

Further, in the case of the use for connectors or terminals, the electrical conductivity depends on whether it is used for signal transmission or power transmission. For signal transmission, it is preferably 60%IACS or more in consideration of preventing of heat generation.

The metal base can be manufactured, for example, by melting and casting a predetermined metal material into an ingot and subjecting the ingot to hot rolling, cold rolling, homogenizing treatment and degreasing in this order by the conventional methods.

In the present invention, methods for providing the resin coating film on the metal base includes (a) a method of arranging a resin coating film with an adhesive agent on a part on the metal base where insulation is required, fusing the adhesive agent by an induction heating roll and performing heating treatment for reaction curing bonding, and (b) a method of coating varnish containing resin or resin precursor dissolved with a solvent, volatilizing or not volatilizing the solvent according to need, and then, performing heating treatment for reaction curing bonding. Whichever method (a) or (b) is adopted, the residual solvent quantity in the resin coating film or adhesive agent after reaction curing is 1 to 30% and thereby high adhesion can be achieved to solve the above-mentioned problems. In consideration of controllability of the residual solvent quantity, the method (b) is more preferable.

In consideration of application to multiple components, the tolerance of the position where the resin coating film is provided on the metal base is preferably ±0.15 mm, more preferably, ±0.10 mm, or much more preferably ±0.05 mm.

In the present invention, the resin for forming the resin coating film is, for example, polyimide, polyamide-imide, polyamide or epoxy resin. As the resin, if it may be subjected to heat treatment such as reflow mounting, coating after forming of the film, the resin is preferably a heat-resistant resin such as polyimide or polyamide-imide resin.

Further, as the insulation of the resin coating film, the volume resistivity is preferably $10^{10}$ $\Omega\cdot$cm or more, or more preferably, $10^{14}$ $\Omega\cdot$cm or more.

When the metal base is coated on its surface with varnish containing resin or resin precursor dissolved with a solvent and is subjected to heat treatment for reaction-curing, the heating temperature is preferably from 100 to 500 ˚C or more preferably, from 200 to 400 ˚C. If the heating temperature is too high, the resin is thermally decomposed after being reaction-cured, or if the heating temperature is too low, it takes much time until the resin is cured and the productivity is deteriorated. In consideration of suppressing of foam of the resin coating film in heating, the temperature increasing speed of the metal base is preferably 45 ˚C/sec or less or more preferably ranges from 10 to 35 ˚C/sec.

As the solvent, methanol, ethanol, toluene, xylene, dimethylformamide (DMF), methyl ethyl ketone (MEK), N-methyl-2-pyrrolidone (NMP), γ-butyl lactone are used preferably.

The concentration of the resin or resin precursor in the varnish in coating preferably ranges from 5 to 40 % by mass or more preferably ranges from 10 to 30 % by mass.

In addition, when the resin coating film is provided on the metal base with use of an adhesive agent, the adhesive agent is of polyimide, epoxy, acrylic or silicone resin. These resins have heat resistance against heating treatment such as solder bonding, reflow solder mounting. If the heating conditions are not so severe, the resin of low heat-resistant property (for example, phenol, polyamide or polyethylene terephthalate resin) may be used instead of the above-mentioned resins.

As to the thickness of the resin coating film, if the film is too shin, insulation cannot be assured enough and pin holes are easily formed. Therefore, the thickness is preferably 2 μm or more, or more preferably 3 μm or more. Meanwhile, if the film is too thick, press workability such as punching and bending is reduced and therefore, the thickness is preferably 50 μm or less, or more preferably 30 μm or less.

In the present invention, it is preferable that at least one resin coating film layer is provided on the metal base and this resin coating film is deposited on the metal base directly or via at least one metal layer.

The above-mentioned metal layer has a single layer or multiple layers. For example, for solder-mounting, the thickness of the metal layer as the outermost layer in the metal layer is preferably 1 μm or more so that solder wetting is held well and fusion bonding such as reflow soldering is applicable. The upper limit is around 20 μm and if the thickness exceeds this value, the effect is saturated. For mounting other than solder-mounting, in view of the corrosion resistance, resin adhesion and the like, the thickness of the meal layer as the outermost layer preferably ranges from 0.1 $\mu$m to 10 $\mu$m, inclusive. The metal layer other than the outermost metal layer also preferably ranges from 0.1 $\mu$m to 10 $\mu$m, inclusive. In the case of multiple layers, they are preferably two layers in view of cost effectiveness. The thickness of each of the multiple layers preferably ranges from 0.1 $\mu$m to 10 $\mu$m, inclusive.

The materials of the metal layer provided on the metal base are determined by the material quality of the metal base, the kind of the used component, the intended purpose, required characteristics, allowable cost and the like. In any case, the material selected is a metal that meets the basic required characteristics for a final component, The above-mentioned metal layer is generally of one metal selected from Ni, Cu, Sn, Ag, Pd and Au or an alloy, eutectoid or compound containing at least one of the above-mentioned metals. In view of the cost effectiveness, Ni, Sn or Ag layer (metal, alloy, eutectoid or compound) is preferably used for the single film, and the inner layer (foundation) of Ni or Cu (metal, alloy, eutectoid or compound) and the outer layer of Sn, Ag, Pd or Au (metal, alloy, eutectoid or compound) are preferably used for the multi-layer film. If the multi-layer film contains three or more layers, Cu, Ag or Pd (metal, alloy, eutectoid or compound) is preferably used in an intermediate layer.

The alloy can be used in the Ni or Cu foundation layer. Its structure is enough to be either a simple substance or simple-substance multi-layer. When the thickness is too small, there are many pinholes formed, and when the thickness is too large, cracking is easy to occur in working. Therefore, the thickness is preferably from 0.1 to 2 $\mu$m.

As the structure in which the foundation is one or more Ni or Cu film and the outer layer is Sn film meets the general requirements and is economical, it is used for general purposes.

As the Sn film, a non-glossy film is suitable rather than a glossy film, and Sn, Sn-Cu, Sn-Ag, Sn-Bi or Sn-Zn film (metal, alloy, eutectoid , compound) is used. As to the materials other than Sn-Bi, a composition near eutectic of which the melting point is low can be used easily.

Particularly, Sn, Sn-Cu and Sn-Ag alloys are excellent in heat resistance. The above-mentioned Sn-Cu and Sn-Ag films are used as by forming alloy films or by forming a Cu layer or Ag layer on the Sn film and alloying the film in melting.

The metal layer is generally provided in the wet process. The wet process includes dip displacement, electroless plating, and electrodepositing. Out of then, the electrodepositing is excellent in the points of stability of the bath, thickness controllability and even thickness of the metal layer. It also has a merit of inexpensive total cost.

The above-mentioned electrodeposition method uses a commercially available bath or well-known plating liquid, and is performed in such a manner that the metal base is cathode, the above-mentioned plating liquid is given at an appropriate relative speed between the cathode and soluble or insoluble anode, and constant current electrodeposition is performed. In order to provide the metal layer partially, a method of masking on an unnecessary part, a method of supplying plating liquid at spots of a necessary part and the like are adopted.

In the present invention, the metal layer is provided only at a necessary part where soldering is performed, and, at the other parts, the metal base may be exposed.

Further, the composite material for electrical/electronic component having the resin coating film formed on the metal base of the present invention can be used in various electric/electronic components. Such components are not limited specifically and include, for example, a connector, a terminal and a shield case, which are adopted in electric/electronic devices such as a portable phone, a portable information terminal, a notebook computer, a digital camera, and a digital video.

The following description is made in detail, with reference to the drawings, about preferable exemplary embodiments of a composite material for electrical/electronic component of the present invention. However, these exemplary embodiments are not intended for limiting the present invention. For example, a resin coating film may be provided on single surface or both surfaces of a metal base or may comprise multiple layers. That is, the exemplary embodiments of the present invention may be modified appropriately in accordance with requested characteristics of the electrical/electronic component as a final product.

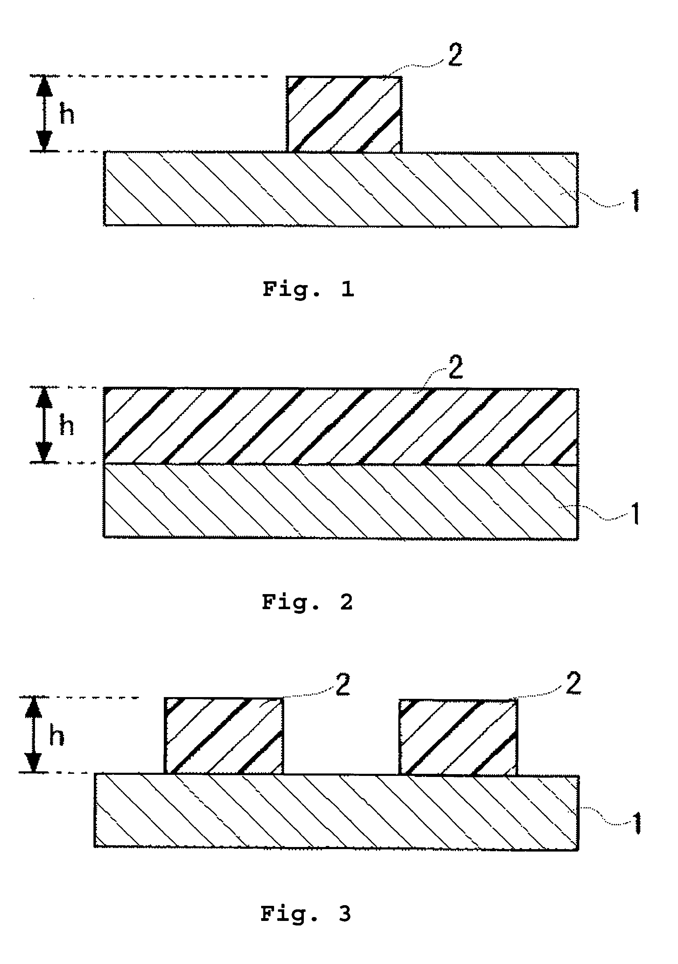

Fig. 1 is an enlarged cross sectional view of a composite material according to a first exemplary embodiment of the present invention. A resin coating film 2 is provided on at least one part on the surface of a metal base 1 where insulation is required. Here, the height from the surface of the base to the surface of the resin coating film is denoted by "h" (this goes for Figs. 2 to 7 explained below).

Fig. 2 is an enlarged cross sectional view of a composite material according to a second exemplary embodiment of the present invention. The resin coating film 2 is provided all over the one-sided surface of the metal base 1.

Fig. 3 is an enlarged cross sectional view of a composite material according to a third exemplary embodiment of the present invention. The resin coating films 2 are provided at two parts on the surface of the metal base 1 where insulation is required.

In the composite materials of the present invention illustrated in Figs. 1 to 3, as the resin coating film 2 is provided at each part where the insulation is required, the function as the composite material can be exerted effectively. For example, when the composite material is used in a case component such as a shield case, insulation between the components can be held well and therefore, it can be advantageously used for miniaturizing of the case. In addition, in Figs. 1 and 3, the metal base is exposed at a part other than where the resin coating film 2 is provided, and therefore, heat dissipation capacity can be maintained at a high degree.

Further, when the composite material is used in an electric connection component such as a connector or terminal, insulation of the material and an adjacent component can be maintained well and therefore, it can be used advantageously in narrowing the pitch of connectors. Furthermore, in Figs. 1 and 3, the metal base is exposed at a part other than where the resin coating film 2 is provided, and therefore, soldering can be performed and heat dissipation capacity can be maintained at a high degree.

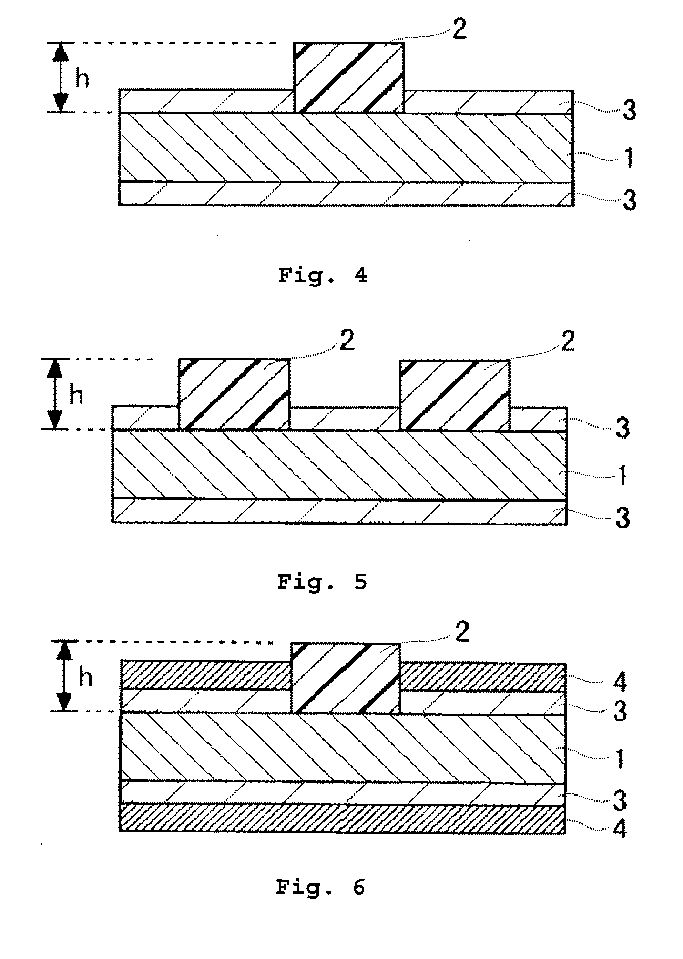

Fig. 4 is an enlarged cross sectional view of a composite material according to a fourth exemplary embodiment of the present invention. The resin coating film 2 is provided on at least a part of the metal base 1 where insulation is required, and a Ni layer 3 is provided on a part of the metal base 1 where the resin coating film 2 is not provided.

Fig. 5 is an enlarged cross sectional view of a composite material according to a fifth exemplary embodiment of the present invention. The resin coating film 2 is provided on two parts of the metal base 1 where insulation is required, and a Ni layer 3 is provided on a part of the metal base 1 where the resin coating film 2 is not provided.

In the composite material illustrated in Figs. 4 and 5, as the Ni layer 3 is provided on the part of the metal base 1 where the resin coating film 2 is not provided, the corrosion resistance can be improved.

Fig. 6 is an enlarged cross sectional view of a composite material according to a sixth exemplary embodiment of the present invention. The resin coating film 2 is provided on at least a part of the metal base 1 where insulation is required, and a Ni layer 3 and a Sn layer 4 are provided in this order on a part of the metal base 1 where the resin coating film 2 is not provided.

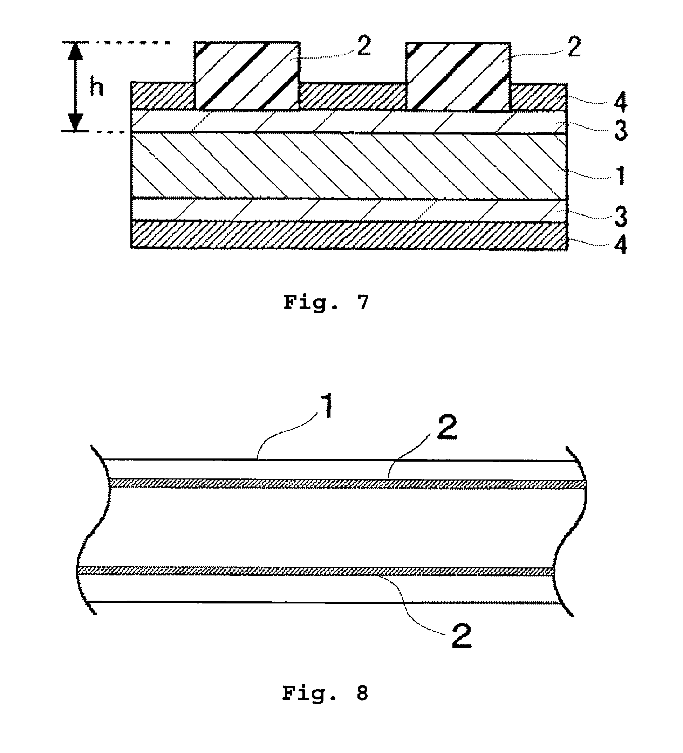

Fig. 7 is an enlarged cross sectional view of a composite material according to a seventh exemplary embodiment of the present invention. The Ni layer 3 is provided on the metal base 1, and then, the resin coating films 2 are provided on two parts of the metal base 1 where insulation is required. A Sn layer 4 is provided on a part of the metal base where the resin coating film 2 is not provided.

In the composite material of the present invention illustrated in Figs. 6 and 7, as the Sn layer 4 is provided at the part of the metal base 1 where the resin coating film 2 is not provided, solder bonding or reflow solder mounting can be easily performed. In addition, as diffusion of components of the metal base 1 is prevented by the Ni layer 3, change in color of the Sn layer 4 can be prevented. Further, in the composite material of the present invention illustrated in Fig. 7, as the resin coating film 2 is provided on the Ni layer 3, adhesion with the resin coating film can be enhanced effectively.

Furthermore, when the two metal layers are provided as illustrated in Figs. 6 and 7, the metal base 1 can be protected well and the heat resistance, oxidation resistance and corrosion resistance of the metal base 1 can be improved. It is also possible to prevent the metal outermost layer from being alloyed or becoming a compound by diffusion of the metal base 1 components.

Particularly, when the Ni layer or Cu layer is provided in the foundation and the Sn layer is provided as the outermost layer, the Sn layer can be well prevented from being a compound and the heat resistance and whisker resistance can be maintained to high degrees advantageously. When three or more metal layers are provided, it becomes more effective, however, two metal layers are suitable in view of the cost effectiveness.

At a part where the resin coating film 2 of the composite material of the present invention is not provided, a heat sink of copper or the like is further provided thereby to be able to enhance heat dissipation capacity drastically. Particularly, in the composite materials illustrated in Figs. 6 and 7, the heat sink can be bonded by soldering easily.

Fig. 8 is a plan view of a composite material according to an eighth exemplary embodiment of the present invention. The resin coating film 2 is provided in stripes on a part of the metal base 1 where insulation is required. The Ni layer 3, or the Ni layer 3 and Sn layer 4 are provided in this order on a part of the metal base 1 where the resin coating film 2 is not provided. Or, the resin coating film 2 may be provided on a part of the Ni layer 3 deposited on the metal base 1 where the insulation is required and the Sn layer 4 may be provided on a part of the Ni layer 3 where the resin coating film 2 is not provided.

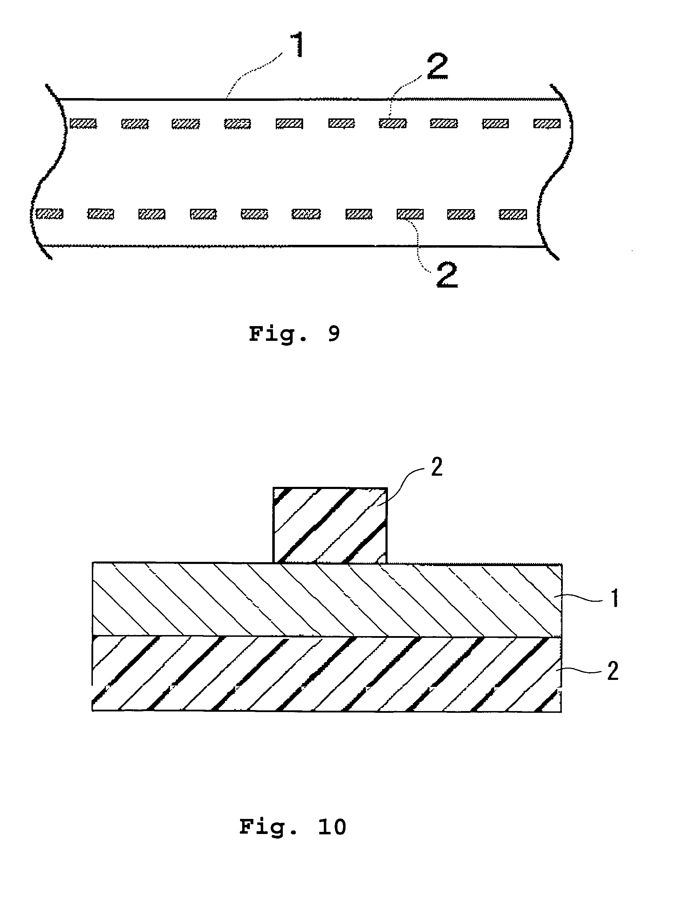

Fig. 9 is a plan view of a composite material according to a ninth exemplary embodiment of the present invention. The resin coating film 2 is provided in spots on a part of the metal base 1 where insulation is required. The other structure is the same as that of the above-mentioned eighth exemplary embodiment.

Fig. 10 is an enlarged cross sectional view of a composite material according to a tenth exemplary embodiment of the present invention.

The resin coating film 2 is provided on at least a part of one surface of the metal base 1 where insulation is required and all over the other surface of the metal base 1. Here, in this figure, though the resin coating film 2 is provided all over the other surface of the metal base 1, it is not indispensable, and the resin coating film 2 may be provided on at least a part of the other surface of the metal base 1.

EXAMPLES

The following description is made in more detail about the present invention based on the examples, however, they are not intended for limiting the present invention.

[EXAMPLE 1]

A strip of JIS alloy C5210R (phosphor bronze, Furukawa Electric Co., Ltd.) having a thickness of 0.1 mm and a width of 20 mm and a strip of SUS304CPS (stainless steel, Nisshin Steel Co., Ltd.) having a thickness of 0.1 mm and a width of 20 mm were used as metal base. The strips were subjected to electrolytic degreasing, acid pickling, water washing and drying in this order.

Then, a varnish (solid: about 30%) containing a polyamide-imide (PAI) solution with N-methyl-2-pyrrolidone (NMP) as a solvent was coated on a center part in the width direction of the metal base at a post-baking coating thickness of 10 $\mu$m($\pm$1 $\mu$m) by a K control coater (RK Print Coat Instruments Ltd. UK) as illustrated in Fig. 5. Then, the predetermined following heating treatment was performed to dry and cure the solvent thereby to provide the resin coating film.

The heating treatment of the samples Nos. 1 to 14 of the present invention example and comparative example samples Nos. 15 to 20 was performed at the furnace temperatures of 200 ˚C, 300 ˚C and 400 ˚C and the time of insertion into the furnace was controlled so that the residual solvent quantity was changed. The temperature rising speed was as follows: furnace temperature 200 ˚C → about 13 ˚C/sec., furnace temperature 300˚C → about 21˚C/sec., furnace temperature 400 ˚C → about 32 ˚C/sec. The residual solvent quantity of 1% to 30%, inclusive, is of the present invention example and the residual solvent quantity of less than 1% or more than 30% is of the comparative example.

The amount of the residual solvent (% by mass) was measured by gas chromatography under the following conditions.

Apparatus: HP5890 + double shot pyrolyzer. PY-2010D (Frontier Laboratories Ltd.)
Colum: Supelco, SPB-20 (30 m $\times$ 0.25 mm ID $\times$ 0.25 $\mu$m)
GC temperature: 50 ˚C (5min) → 10 ˚C/min → 280 ˚C (hold)
Insertion temperature: 280 ˚C
Insertion method: Split (30:1)
Detection method: FID
Det temperature: 280 ˚C
The samples were cut into 2 mm x 10 mm and heated at 300 ˚C for 5 minutes by gas chromatography (GC). Then, the generated gas was measured. The number of samples is five and measured values are arithmetic average values.

As to the obtained material samples for electrical/electronic component of the present invention example and comparative example, punching workability and bending workability were evaluated as press workability.

In evaluation of punching workability, a die with clearance 5% was used to cut each sample into 5 mm x 10 mm square shape, and the sample was immersed into a solution in which red ink was dissolved. Then, the light microscope was used to observe resin at a punching end. The peel width of the resin which is less than 5 $\mu$m (excellent) is marked "◎ (double circle) ", the peel width which is equal to or more than 5 $\mu$m and less than 10 $\mu$m (good) is marked "○", and the peel width which is equal to or more than 10 $\mu$m (poor) is marked "×".

In evaluation of the bending workability, a die with clearance 5% was used to cut each sample into 5 mm x 10 mm square shape, a die having a curvature radius of 0.1 mm and a bending angle of 120 degrees devised to perform bending at the position 1 mm from the sample end was used to perform bending and then, the light microscope (x 40) was used to observe peel-off of resin at the bending inside and peel-off of resin at an end of the extended bending outside. At the same time, wrinkle, crack and peel-off were observed in the resin coating film at the bended part. As to observation results, a sample with no wrinkle and no crack (excellent) is marked "◎(double circle)", a sample with no crack, no peel-off but wrinkle which can be used without problem (good) is marked "○", and a sample with wrinkle, crack and peel-off (poor) is marked "×".

The peel strength (kN/m) was measured with reference to IPC-TM-650 2.4.9.(Peel Strength, Flexible Printed Wiring Materials). The tensile property was measured by preparing a sample resin cut with a width of 3.2 mm and pulling the sample resin 228.6 mm at a speed of 50 mm/min.

The obtained results are shown in the table 1. As shown in the table 1, the samples Nos. 1 to 14 of the present invention example are excellent in peel strength and press workability and the samples Nos. 15 to 20 of the comparative example are poor in peel strength and press workability.

TABLE 1

| Resin: polyamide-imide (PAI) | | | | | | | |
|---|---|---|---|---|---|---|---|
| No. | | Residual solvent quantity(%) | Peel strength (kN/m) | Press workability | | Furnace temperature (°C) | Base |
| | | | | Punching | Bending | | |
| Present invention example | 1 | 1.3 | 0.54 | ○ | ○ | 400 | C5210 |
| | 2 | 2.0 | 0.66 | ○ | ○ | 400 | SUS |
| | 3 | 2.6 | 0.73 | ○ | ○ | 300 | C5210 |
| | 4 | 3.2 | 0.90 | ○ | ○ | 400 | C5210 |
| | 5 | 3.8 | 0.96 | ○ | ◎ | 300 | SUS |
| | 6 | 4.9 | 0.93 | ○ | ◎ | 400 | SUS |
| | 7 | 5.9 | 1.09 | ◎ | ◎ | 300 | C5210 |
| | 8 | 8.4 | 1.18 | ◎ | ◎ | 200 | C5210 |
| | 9 | 8.9 | 1.10 | ◎ | ◎ | 300 | SUS |
| | 10 | 11.8 | 1.05 | ◎ | ◎ | 200 | SUS |
| | 11 | 12.6 | 1.11 | ◎ | ◎ | 300 | C5210 |
| | 12 | 16.5 | 0.97 | ○ | ◎ | 200 | C5210 |
| | 13 | 22.0 | 0.84 | ○ | ○ | 200 | SUS |
| | 14 | 27.4 | 0.62 | ○ | ○ | 200 | C5210 |
| Comparative example | 15 | 0.3 | 0.07 | × | × | 400 | SUS |
| | 16 | 0.6 | 0.23 | × | × | 400 | SUS |
| | 17 | 0.7 | 0.25 | × | × | 400 | C5210 |
| | 18 | 0.8 | 0.31 | × | × | 400 | SUS |
| | 19 | 30.9 | 0.36 | × | × | 200 | SUS |
| | 20 | 36.6 | 0.19 | × | × | 300 | C5210 |

[EXAMPLE 2]

Instead of the varnish (solid: about 30%) containing a polyamide-imide (PAI) solution with N-methyl-2-pyrrolidone (NMP) as a solvent, a varnish (solid: about 20%) containing a polyimide (PI) solution with N-methyl-2-pyrrolidone (NMP) as a solvent was used and the other process was the same as that in Example 1 and thereby, the present invention example samples Nos. 21 to 34 and comparative example samples Nos. 35 to 40 were obtained. The furnace temperature of the heating treatment of each example is shown in Table 2.

Measurement of the obtained samples was performed in the same method as Example 1. The obtained results are shown in Table 2. As shown in Table 2, the samples Nos. 21 to 34 of the present invention example are excellent in peel strength and press workability and the samples Nos. 35 to 40 of the comparative example are poor in peel strength and press workability.

TABLE 2

| Resin: polyimide (PI) | | | | | | | |
|---|---|---|---|---|---|---|---|
| No. | | Residual solvent quantity(%) | Peel strength (kN/m) | Press workability | | Furnace temperature (°C) | Base |
| | | | | Punching | Bending | | |
| Present invention example | 21 | 1.3 | 0.57 | ○ | ○ | 400 | C5210 |
| | 22 | 2.3 | 0.64 | ○ | ○ | 400 | SUS |
| | 23 | 2.5 | 0.69 | ○ | ○ | 300 | C5210 |
| | 24 | 3.6 | 0.88 | ○ | ◎ | 400 | C5210 |
| | 25 | 4.1 | 0.96 | ○ | ◎ | 300 | SUS |
| | 26 | 4.9 | 0.96 | ○ | ◎ | 400 | SUS |
| | 27 | 5.8 | 1.06 | ◎ | ◎ | 300 | C5210 |
| | 28 | 8.1 | 1.07 | ◎ | ◎ | 200 | C5210 |
| | 29 | 8.7 | 1.15 | ◎ | ◎ | 300 | SUS |
| | 30 | 12.1 | 1.04 | ◎ | ◎ | 200 | SUS |
| | 31 | 12.5 | 1.13 | ◎ | ◎ | 300 | C5210 |
| | 32 | 17.3 | 0.99 | ○ | ◎ | 200 | C5210 |
| | 33 | 24.1 | 0.85 | ○ | ○ | 200 | SUS |
| | 34 | 28.2 | 0.64 | ○ | ○ | 200 | C5210 |
| Comparative example | 35 | 0.3 | 0.09 | × | × | 400 | SUS |
| | 36 | 0.6 | 0.25 | × | × | 400 | SUS |
| | 37 | 0.8 | 0.29 | × | × | 400 | C5210 |
| | 38 | 0.9 | 0.33 | × | × | 400 | SUS |
| | 39 | 31.0 | 0.39 | × | × | 200 | SUS |
| | 40 | 37.6 | 0.22 | × | × | 300 | C5210 |

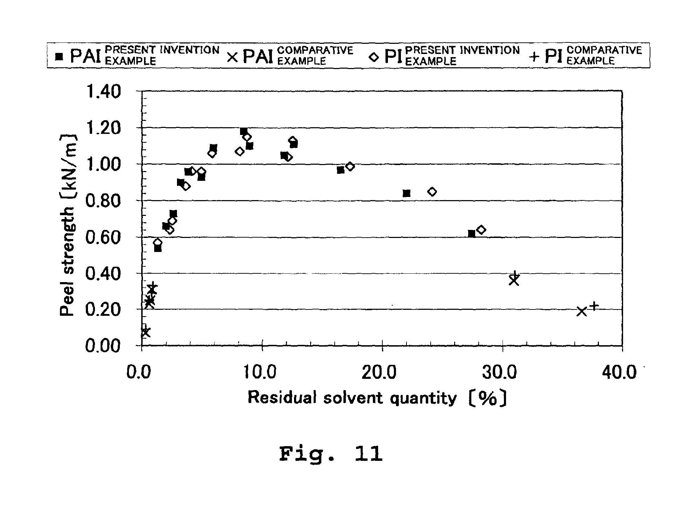

The relation between the peel strength and the residual solvent quantity obtained of Examples 1 and 2 and comparative examples is illustrated in Fig. 11. As is clear from Fig. 11, the peel strength of the present invention when the residual solvent quantity ranges from 1 to 30 % by mass is higher than that of the comparative examples, much higher in the residual solvent range of from 3 to 20 % by mass and further higher in the residual solvent range of from 5 to 15 % by mass. Besides, from Tables 1 and 2, the press workability is good in the residual solvent quantity range of 1 to 30 % by mass of the present invention examples, the bending workability is extremely excellent in the residual solvent quantity range of 3 to 20 % by mass, and the punching workability and bending workability are both extremely excellent in the residual solvent quantity range of 5 to 15 % by mass.

[EXAMPLE 3]

Then, a varnish (solid: about 30%) containing a polyamide-imide solution with N-methyl-2-pyrrolidone (NMP) as a solvent was used, coating and baking were repeated in the same way of Example 1 to one to three layers and the post-baking resin thicknesses was changed between 5 and 50 $\mu$m. Then, samples Nos. 41 to 54 of the present invention and samples Nos. 55 to 60 of the comparative example were obtained. The number of coatings, resin thickness and furnace temperature in heating treatment of each sample are shown in Table 3. Here, as to a sample having plural resin layers, the residual solvent quantity is a residual solvent quantity in whole resin obtained after the last layer is provided and the resin thickness is a sum of thicknesses of respective layers.
Measurement of the obtained samples was performed in the same way as Example 1. The obtained results are shown in Table 3. As shown in Table 3, the samples Nos. 41 to 54 of the present invention example are excellent in peel strength and press workability and the samples Nos. 55 to 60 of the comparative example are poor in peel strength and press workability. This shows the present invention is effective even when multiple layers of resin are provided.
TABLE 3

| No. | | Residual solvent quantity(%) | Peel strength (kN/m) | Press workability | | Number of coatings | Resin thickness (µm) | Furnace temperature (˚C) | Base |
|---|---|---|---|---|---|---|---|---|---|
| | | | | Punching | Bending | | | | |
| Present invention example | 41 | 1.1 | 0.51 | ○ | ○ | 1 | 5 | 400 | C5210 |
| | 42 | 4.5 | 0.99 | ○ | ○ | 1 | 15 | 300 | C5210 |
| | 43 | 3.3 | 0.89 | ○ | ◎ | 2 | 7+7=14 | 300 | C5210 |
| | 44 | 3.2 | 0.95 | ○ | ◎ | 2 | 5+10=15 | 300 | C5210 |
| | 45 | 3.5 | 0.93 | ○ | ◎ | 2 | 10+5=15 | 300 | C5210 |
| | 46 | 7.9 | 1.21 | ◎ | ◎ | 1 | 20 | 400 | SUS |
| | 47 | 8.8 | 1.21 | ◎ | ◎ | 2 | 10+10=20 | 400 | SUS |
| | 48 | 8.4 | 1.18 | ◎ | ◎ | 2 | 5+15=20 | 400 | SUS |
| | 49 | 8.9 | 1.23 | ◎ | ◎ | 2 | 15+5=20 | 400 | SUS |
| | 50 | 16.5 | 1.03 | ○ | ◎ | 2 | 15+15=30 | 200 | SUS |
| | 51 | 18.9 | 0.93 | ○ | ○ | 3 | 5+10+15=30 | 200 | SUS |
| | 52 | 20.1 | 0.87 | ○ | ○ | 3 | 15+10+5=30 | 200 | SUS |
| | 53 | 20.5 | 0.91 | ○ | ○ | 3 | 10+10+10=30 | 200 | SUS |
| | 54 | 21.1 | 0.89 | ○ | ○ | 3 | 10+10+10=30 | 200 | C5210 |
| Comparative example | 55 | 0.3 | 0.05 | × | × | 1 | 3 | 400 | C5210 |
| | 56 | 0.6 | 0.27 | × | × | 2 | 10+10=20 | 400 | SUS |
| | 57 | 0.5 | 0.29 | × | × | 2 | 15+5=20 | 400 | SUS |
| | 58 | 0.6 | 0.28 | × | × | 2 | 5+15=20 | 400 | SUS |
| | 59 | 35.5 | 0.22 | × | × | 1 | 30 | 200 | SUS |
| | 60 | 32.2 | 0.35 | × | × | 3 | 10+10+10=30 | 300 | C5210 |

The present invention has been described by way of its exemplary embodiments. However, the present invention is not limited by any detail part in the description unless specified otherwise. The present invention shall be understood broadly without departing from the spirit and scope of the present invention defined in the claims attached hereto.

The present application claims priority under 35 U.S.C. § 119 (a) on Japanese Patent application No. 2008-009886 filed on January 18, 2008, and Japanese Patent application No. 2008-166402 filed on June 25, 2008, entire contents of which are incorporated by reference herein.

## Claims

1. A composite material for electrical/electronic component, having a resin coating film formed on at least a part of a metal base, and a residual solvent quantity in the resin coating film being controlled to be 1-30% by mass.

2. A composite material for electrical/electronic component, having a resin coating film formed by coating at least a part of a metal base with a varnish containing a resin or a resin precursor dissolved in a solvent and performed heating treatment for reaction curing, and the composite material being to be subjected to press working, wherein a residual solvent quantity after reaction curing of the resin coating film is controlled to be 1 to 30% by mass so that adhesion between the resin coating film and the metal base in the press working and press workability are both excellent.

3. The composite material of claim 1 or 2, wherein the resin coating film is composed of a polyimide or a polyamide-imide.

4. The composite material of any one of claims 1 to 3, wherein the metal base is of copper, copper alloy, iron or iron alloy.

5. The composite material of any one of claims 1 to 4, wherein the residual solvent quantity is controlled to be 3 to 20% by mass.

6. The composite material of any one of claims 1 to 4, wherein the residual solvent quantity is controlled to be 5 to 15% by mass.

7. An electrical/electronic component using the composite material of any one of claims 1 to 6.

8. A method for producing the composite material of any one of claims 1 to 6, comprising performing the reaction curing of the resin coating film at temperatures of 100 to 500 degrees.

9. The method of claim 8, wherein the reaction curing of the resin coating film is performed at a temperature rising speed of 45 ˚C/second or less.

h

2

1

**Fig. 1**

h

2

1

**Fig. 2**

h

2

2

1

**Fig. 3**

Fig. 4

Fig. 5

Fig. 6

Fig. 7

Fig. 8

Fig. 9

Fig. 10

Fig. 11

22  20
23
21
21a
21

**Fig. 12**

34  30
32
31  33

**Fig. 13**

**INTERNATIONAL SEARCH REPORT**

| International application No. |
| --- |
| PCT/JP2009/050485 |

A.   CLASSIFICATION OF SUBJECT MATTER
*B32B15/08*(2006.01)i, *B32B15/088*(2006.01)i, *H01B17/62*(2006.01)i, *H05K1/03*(2006.01)i

According to International Patent Classification (IPC) or to both national classification and IPC

B.   FIELDS SEARCHED

Minimum documentation searched (classification system followed by classification symbols)
B32B15/08-15/098, H01B17/62, H05K1/03-1/05

Documentation searched other than minimum documentation to the extent that such documents are included in the fields searched
Jitsuyo Shinan Koho          1922-1996   Jitsuyo Shinan Toroku Koho    1996-2009
Kokai Jitsuyo Shinan Koho    1971-2009   Toroku Jitsuyo Shinan Koho    1994-2009

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
| --- | --- | --- |
| X | JP 2005-108927 A  (SUMITOMO ELECTRIC WINTEC, INC.), 21 April, 2005 (21.04.05), Claims; Par. No. [0046]; examples (Family: none) | 1-9 |
| X | JP 10-168409 A  (Hitachi Chemical Co., Ltd.), 23 June, 1998 (23.06.98), Claims; Par. No. [0008]; examples (Family: none) | 1,3-7 |

☐   Further documents are listed in the continuation of Box C.        ☐   See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered   to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 06 April, 2009 (06.04.09) | 14 April, 2009 (14.04.09) |

| Name and mailing address of the ISA/ | Authorized officer |
| --- | --- |
| Japanese Patent Office | |
| Facsimile No. | Telephone No. |

Form PCT/ISA/210 (second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 1006389 A
- JP 2004197224 A
- JP 2802402 B
- JP 5245432 A
- JP 2001105530 A
- JP 2005117058 A
- JP 2008009886 A
- JP 2008166402 A